Europäisches Patentamt

European Patent Office

Office européen des brevets

(11) Veröffentlichungsnummer: **0 087 501**
**A2**

(12) ## EUROPÄISCHE PATENTANMELDUNG

(21) Anmeldenummer: 82109765.6

(22) Anmeldetag: 22.10.82

(51) Int. Cl.³: **H 03 K 5/08**

(30) Priorität: 27.02.82 DE 3207144

(43) Veröffentlichungstag der Anmeldung:
07.09.83 Patentblatt 83/36

(84) Benannte Vertragsstaaten:
DE FR GB NL

(71) Anmelder: ROBERT BOSCH GMBH
Postfach 50
D-7000 Stuttgart 1(DE)

(72) Erfinder: Hankel, Rainer, Dipl.-Ing.
Marmaraweg 49
D-1000 Berlin 42(DE)

(74) Vertreter: Schmidt, Hans-Ekhardt
Robert Bosch GmbH Geschäftsbereich Elektronik
Patent- und Lizenzabteilung Forckenbeckstrasse 9-13
D-1000 Berlin 33(DE)

(54) **Triggerschaltung.**

(57) Es wird eine Triggerschaltung vorgeschlagen, die aus einem hohe und tiefe Frequenzen aufweisenden Frequenzgemisch die Anteile der höchsten Frequenzen ableitet und in Rechteckimpulse umwandelt. Damit die Triggerschaltung auch ein Frequenzgemisch auswerten kann, bei dem eine Signalspannung mit tieferen Frequenzen gegebenenfalls größer sein darf als die Signalspannung der abzuleitenden höchsten Frequenzen, wird erfindungsgemäß eine Schaltung vorgeschlagen, die einen Spitzenspannungsdetektor aus einem Operationsverstärker (13) mit einer Antiparallelschaltung (19) aus zwei Dioden (20, 21) im Gegenkopplungsweg aufweist und deren erster Eingang (15) den Eingang (11) der Triggerschaltung (10) bildet und deren zweiter Eingang (17) über einen Kondensator (23) mit einem festen Potential verbunden ist. An den Spitzenspannungsdetektor schließt sich ein Komparator an, der einen zweiten Operationsverstärker (14) enthält, dessen erster Eingang (16) mit dem Ausgang (22) des ersten Operationsverstärkers und dessen zweiter Eingang (18) mit dem ersten Eingang (15) des ersten Operationsverstärkers verbunden ist.

Fig. 1

12/82
EK/PLI Scht/Li
26. 2. 1982


ROBERT BOSCH GMBH, 7OOO Stuttgart 1


Triggerschaltung


Stand der Technik


Die Erfindung geht von einer Triggerschaltung nach
der Gattung des Hauptanspruchs aus.

Es ist schon eine Triggerschaltung bekannt (Hewlett-
Packard Journal, Januar 1981, Seiten 4 bis 8), die
zur Signalaufbereitung eines Bar-Kode-Lesers dient.
Die bekannte Triggerschaltung weist im wesentlichen
einen ersten gegengekoppelten Operationsverstärker,
einen Spitzenspannungsdetektor und einen zweiten,
als Komparator verwendeten Operationsverstärker auf.
Mit der bekannten Triggerschaltung werden aus einem
bandbegrenzten Frequenzgemisch die Anteile der höchsten Frequenz abgeleitet und am Ausgang der Schaltung als Rechteckimpulse abgegeben. Eine derartige
Schaltung wird benötigt, um zum Beispiel bei einem
fotoelektrischen Wandler zwischen dem höherfrequenten Nutzsignal und einem niederfrequenten oder durch
zufällig schwankendes Störlicht hervorgerufenen Störsignal unterscheiden zu können. Die bekannte Schaltung hat jedoch den Nachteil, daß das zu verarbeitende Nutzsignal größer als die Schwellspannung der
Dioden des Spitzenspannungsdetektors sein muß. Diese
Bedingung läßt sich oft nicht erfüllen, zum Beispiel,
wenn dem Nutzsignal ein nichtunterdrückbares niederfrequentes Störsignal großer Amplitude überlagert
ist, das bei hoher Verstärkung zur Übersteuerung
führt.

Vorteile der Erfindung

Die erfindungsgemäße Triggerschaltung mit den kennzeichnenden Merkmalen des Hauptanspruchs hat den Vorteil, daß
Wechselspannungssignale mit nichtdefiniertem Gleichspannungsanteil in Rechteckimpulse umgeformt werden können,
wozu Komparator- oder Schmitt-Triggerschaltungen nicht
geeignet sind. Aus einem bandbegrenzten Frequenzgemisch
kann mit der erfindungsgemäßen Schaltung ohne Filterung
die höchste Frequenz des Frequenzgemischs ermittelt werden. Dabei kann die Ampitude des mit Störsignalen überlagerten Nutzsignals in weiten Grenzen schwanken, ohne
daß dadurch die Sicherheit der Auswertung beeinträchtigt
wird.

Zeichnung

Ein Ausführungsbeispiel der Erfindung ist in der Zeichnung
anhand mehrerer Figuren dargestellt und in der nachfolgenden Beschreibung näher erläutert. Die Zeichnung zeigt in

Fig. 1    ein Blockschaltbild der erfindungsgemäßen
          Triggerschaltung,

Fig. 2A   den Spannungsverlauf von Nutz- und Störsignal in Abhängigkeit von der Zeit,

Fig. 2B   den Spannungsverlauf an Schaltungspunkten
          B und D in Abhängigkeit von der Zeit,

Fig. 2C   den Spannungsverlauf der am Ausgang der
          Triggerschaltung liegenden Spannung in
          Abhängigkeit von der Zeit und

Fig. 3    ein Blockschaltbild der erfindungsgemäßen
          Triggerschaltung in einer alternativen
          Ausführungsform.

Beschreibung der Erfindung

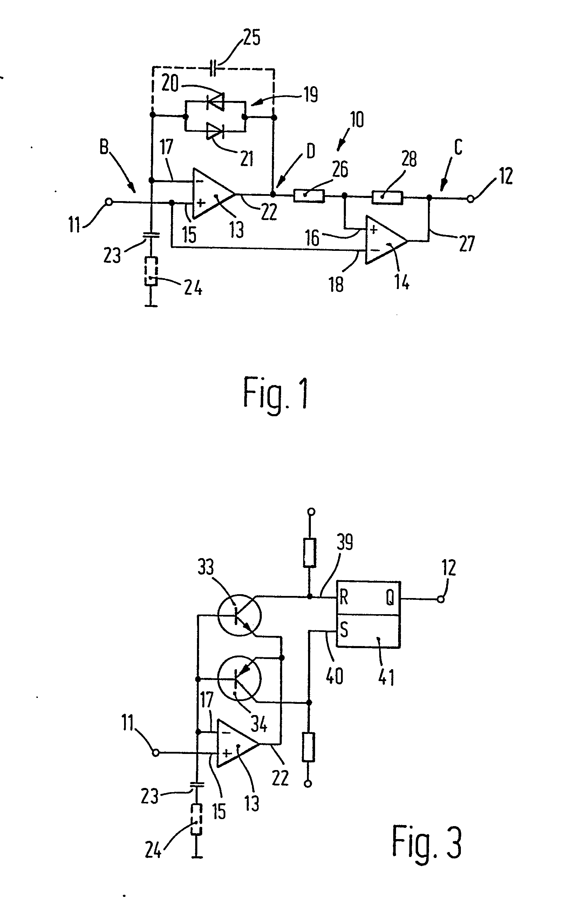

In Fig. 1 bezeichnet 10 eine erfindungsgemäße Triggerschaltung, die einen Eingang 11 und einen Ausgang 12 aufweist. Die Triggerschaltung umfaßt zwei Operationsverstärker 13, 14 mit je einem ersten Eingang 15, 16 und je einem zweiten Eingang 17, 18. Die ersten Eingänge 15, 16 sind nichtinvertierende Eingänge und die zweiten Eingänge 17, 18 invertierende Eingänge der Operationsverstärker.

Der Eingang 11 der Triggerschaltung steht erstens mit dem ersten Eingang 15 des ersten Operationsverstärkers 13 und zweitens unmittelbar mit einem zweiten Eingang 18 des zweiten Operationsverstärkers 14 in Verbindung.

Der zweite Eingang 17 des ersten Operationsverstärkers 13 steht erstens über eine Antiparallelschaltung 19 aus zwei Dioden 20, 21 mit einem Ausgang 22 des ersten Operationsverstärkers und zweitens über einen Kondensator 23 und einen gegebenenfalls vorhandenen Widerstand 24 mit einem festen Potential, zum Beispiel Masse, in Verbindung. Die Antiparallelschaltung 19 kann gegebenenfalls durch einen Kondensator 25 überbrückt sein. Zwischen dem Ausgang 22 des ersten Operationsverstärkers 13 und dem ersten Eingang 16 des zweiten Operationsverstärkers 14 liegt ein Widerstand 26. Der erste Eingang 16 des zweiten Operationsverstärkers 14 und ein Ausgang 27 dieses Operationsverstärkers sind durch einen Gegenkopplungswiderstand 28 miteinander verbunden.

Während der erste Operationsverstärker 13 zusammen mit der Antiparallelschaltung 19 und dem Kondensator 23 einen Spitzenspannungsdetektor bildet, entsteht aus dem zweiten Operationsverstärker 14 in Verbindung mit den beiden Widerständen 26, 28 ein Komparator.

Die Wirkungsweise der vorstehend beschriebenen Schaltung
ist folgende.

Sind eine Nutzspannung 30 und eine Störspannung 31 (vgl.

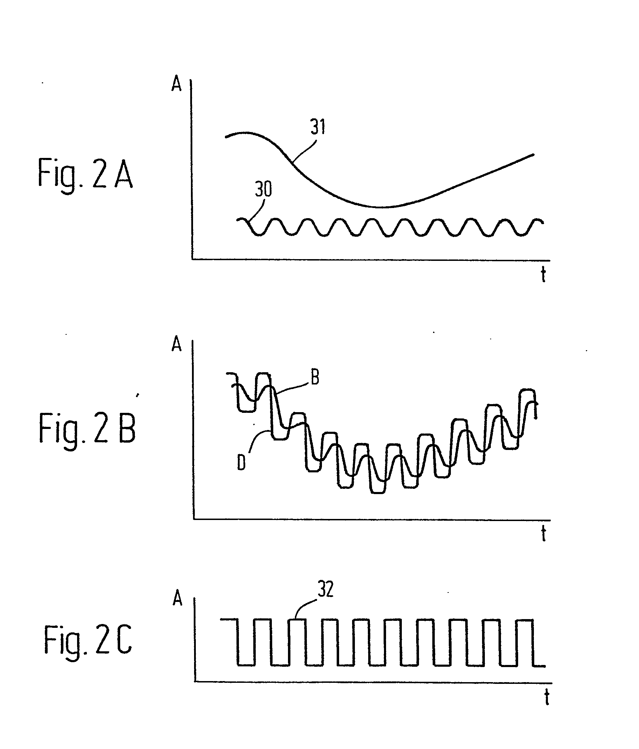

Fig. 2A) vorhanden und liegen diese beiden Spannungen am
Eingang 11 der Triggerschaltung 10, so überlagern sich
diese beiden Spannungen; vgl. Fig. 2B, Spannungsverlauf B.
Das Signalgemisch aus den beiden Spannungen liegt an dem
ersten Eingang 15, das ist der nichtinvertierende Eingang
des ersten Operationsverstärkers 13. Das Ausgangssignal D
des Spitzenspannungsdetektors wird mit dem Eingangssignal B in dem den zweiten Operationsverstärker 14 enthaltenden Komparator verglichen. Der Ausgang 12 der
Triggerschaltung 10 gibt dann eine Impulsfolge 32 aus
Rechteckimpulsen ab (Fig. 2C), deren Impulsfolgefrequenz
der Frequenz der Nutzspannung 30 (vgl. Fig. 2A) entspricht.

Zur Beeinflussung des Stabilitäts- und Frequenzverhaltens
des Spitzenspannungsdetektors ist es von Vorteil, den Kondensator 25 und den Widerstand 24 vorzusehen. Die Dioden
20, 21 der Antiparallelschaltung 19 sind durch Basis-
Emitterstrecken von Transistoren 33, 34 ersetzbar, aus
deren Kollektorströmen Signale zur Impulsformung unter
Umgehung der Komparatorstufe ableitbar sind; vgl. Fig. 3.

In dem Ausführungsbeispiel nach Fig. 3, in der für gleiche
Schaltungspunkte und Bauteile wie in Fig. 1 gleiche Bezugszahlen verwendet werden, stehen die Kollektoren der die
Dioden ersetzenden Transistoren 33, 34 unmittelbar mit je
einem Eingang 39, 40 einer RS-Flipflopschaltung 41 in Verbindung. Die Flipflopschaltung sorgt dafür, daß am Ausgang 12 die rechteckförmigen Spannung 32 gemäß Fig. 2C zur
Verfügung steht.

Eine sichere Funktion der Triggerschaltung ist gewährleistet, wenn das Produkt aus Leerlaufverstärkung $V_o$ des
ersten Operationsverstärkers 13 und Spitzenspannung $U_{SS}$
des Nutzsignals 30 am Eingang 11 der Triggerschaltung 10
größer oder gleich der Flußspannung $U_D$ der beiden Dioden
20, 21 ist.

12/82
EK/PLI Scht/Li
26. 2. 1982

ROBERT BOSCH GMBH, 7000 Stuttgart 1

Ansprüche

1. Triggerschaltung, die aus einem hohe und tiefe
   Frequenzen aufweisenden Frequenzgemisch die
   Anteile der höchsten Frequenzen ableitet und
   in Rechteckimpulse umwandelt, unter Verwendung
   eines Spitzenspannungsdetektors mit antiparallelgeschalteten Dioden und einem nachgeschalteten Komparator, dadurch gekennzeichnet,
   daß der Spitzenspannungsdetektor einen ersten
   Operationsverstärker (13) enthält, dessen
   zweiter Eingang (17) und Ausgang (22) über die
   antiparallelgeschalteten Dioden (20, 21) verbunden sind und dessen erster·Eingang (15) mit
   dem Eingang (11) der Triggerschaltung (10) und
   unmittelbar mit dem zweiten Eingang (18) des
   einen Komparator bildenden zweiten Operationsverstärkers (14) verbunden ist, dessen Ausgang
   (27) den Ausgang (12) der Triggerschaltung
   bildet, und daß zwischen dem zweiten Eingang
   (17) des ersten Operationsverstärkers und einem
   festen Potential ein Kondensator (23) geschaltet
   ist.

2. Triggerschaltung nach Anspruch 1, dadurch gekennzeichnet, daß den antiparallelgeschalteten
   Dioden (20, 21) ein Kondensator (25) parallelgeschaltet ist.

- 2 -

**0087501**

3. Triggerschaltung nach Anspruch 1 oder 2, dadurch gekennzeichnet, daß dem zwischen dem zweiten Eingang (17) des ersten Operationsverstärkers (13) und Masse liegenden Kondensator (23) ein Widerstand (24) in Reihe geschaltet ist.

4. Triggerschaltung nach Anspruch 1, 2 oder 3, dadurch gekennzeichnet, daß die Dioden des Spitzenspannungsdetektors aus den Basis-Emitterstrecken zweier Transistoren (33, 34) bestehen, aus deren Kollektorströmen Signale ableitbar sind, die nach einer Impulsformung die Rechteckimpulse bilden.

Fig. 1

Fig. 3

A

Fig. 2 A

31

30

t

A

Fig. 2 B

B

D

t

A

32

Fig. 2 C

t